(19) Europäisches Patentamt
European Patent Office
Office européen des brevets

(11) **EP 3 891 232 B1**

(12) **EUROPEAN PATENT SPECIFICATION**

(45) Date of publication and mention
of the grant of the patent:
**01.11.2023  Bulletin 2023/44**

(21) Application number: **19821192.2**

(22) Date of filing: **09.12.2019**

(51) International Patent Classification (IPC):
**C09D 11/52** (2014.01)   **C09D 11/38** (2014.01)
**C09D 11/322** (2014.01)

(52) Cooperative Patent Classification (CPC):
**C09D 11/52; C09D 11/322; C09D 11/38**

(86) International application number:
**PCT/GB2019/053478**

(87) International publication number:
**WO 2020/115509 (11.06.2020 Gazette 2020/24)**

(54) **INKJET PRINTING OF CONDUCTIVE TRACES**

TINTENSTRAHLDRUCK VON LEITERBAHNEN

IMPRESSION À JET D'ENCRE DE TRACES CONDUCTRICES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **07.12.2018   GB 201819982**

(43) Date of publication of application:
**13.10.2021   Bulletin 2021/41**

(73) Proprietor: **UEA Enterprises Limited
Norwich NR4 7TJ (GB)**

(72) Inventors:
• **MAVURI, Arunakumari
Norwich Norfolk NR4 7TJ (GB)**
• **MAYES, Andrew
Norwich Norfolk NR4 7TJ (GB)**
• **ALEXANDER, Matthew Simon
Norwich Norfolk NR4 7TJ (GB)**

(74) Representative: **Haseltine Lake Kempner LLP
One Portwall Square
Portwall Lane
Bristol BS1 6BH (GB)**

(56) References cited:
**US-A1- 2007 056 402     US-A1- 2007 283 848
US-A1- 2007 289 483     US-A1- 2014 009 545**

## Description

Field of the Invention

This invention is directed to methods of inkjet printing conductive traces, as well as inkjet ink compositions for use therein and methods of making such inkjet ink compositions.

Background of the Invention

Printed electronics technology uses various types of printing equipment to develop electronic devices on different substrates, such as glass, polyethylene terephthalate (PET), paper and polyimide (PI). There are a wide range of advantages to printed electronics technologies over conventional techniques, including simpler production, low cost, an increased variety of substrates and the ability to achieve large-scale production. Moreover, printed electronics enables the production of flexible electronics, as well as the application of conductive traces on heat- or pressure-sensitive materials. Additionally, the additive nature of printing techniques ensures that electronics can be produced with reduced material wastage and the consumption of lower volumes of chemicals, resulting in environmental benefits.

Various applications for this technology are currently being developed, including its use in the fabrication of flexible batteries, electro-optic devices, displays, organic photovoltaics, logic and memory components such as thin film transistors (TFTs), sensors and radio frequency identification (RFID) tags. Some projections indicate that the total market for printed, flexible and organic electronics will increase significantly over the next decade and that, within this growth, the majority of the market trend is towards the production of OLEDs (organic light emitting diodes) and conductive inks.

Conductive inks are typically prepared by using conductive materials to print conductive layers on a substrate without changing the properties of the material. The conductive materials used in these ink compositions can be based on conductive polymers, carbon-based materials or metal particles. Generally, metal particles are the high conducting materials but it is impossible to disperse a pure metal in any of the common solvent systems used in printing. Moreover, the use of pure metals would also require high temperatures to be used to sinter the printed traces after printing. Alternatively, the size of the metal may be reduced to nanoparticle dimensions to reduce the temperature required to sinter the printed traces. However, the reactive nature of metal nanoparticles means that it may be necessary to coat or cap the metal with polymer chains to prevent oxidation prior to sintering and to enable dispersion of the metal in the solvent system.

A wide range of metal nanoparticles have been investigated for printed electronics applications. Metallic nanoparticle ink compositions are typically composed of Cu, Ag or Au. Of these, copper is the most economical metal but the ease of oxidation of copper in air decreases the conductivity. Although gold has high conductivity and thermal stability it is too expensive for mass production. Therefore, silver is the most studied metal for use in metallic nanoparticle based ink compositions due to its good oxidation resistance in air, high conductivity and lower cost.

To fuse the nanoparticles after printing and produce a highly conductive printed trace it is necessary to remove any capping agent that is present. This is typically achieved by thermal or chemical sintering methods. For thermal sintering, the typical temperature required to decompose the organic stabilizers on the metal nanoparticles is above 200°C. However, such high temperatures render it impossible to use low-cost flexible substrates, such as paper and plastic, because they are thermally sensitive, typically limiting processing temperatures to below 150°C.

Furthermore, to achieve high quality printed conductive traces, it is necessary to develop conductive ink compositions for inkjet printing with suitable physical properties. An improper selection of the inkjet ink composition leads to unstable ink jetting, satellite production or splashing on impact and poor quality printed images (traces). The major parameters that affect drop performance and size are viscosity, density and surface tension.

Recently, a low temperature chemical sintering method has been developed for the sintering of silver (Ag) nanoparticles (NPs). It has been shown that poly(acrylic acid) (PAA) capped Ag NPs can be chemically sintered by simple exposure to chloride ions to break the bonds between the PAA molecules and the metal nanoparticles. On breaking of the bonds to the PAA, the Ag NPs undergo fusion and produce highly conductive silver deposits. Further details can be found in the article authored by Shlomo Magdassi, Michael Grouchko, Oleg Berezin, and Alexander Kamyshny: ACS Nano, 2010, 4 (4), pp 1943-1948. Additionally, poly(vinyl pyrrolidone)-capped silver nanoparticles have been shown to be suitable for chemical sintering of metal nanoparticles. To provide a composition suitable for use in inkjet printing, the Ag NPs were dispersed in a variety of different solvents, including water and a mixture of water and ethylene glycol. However, while the printed traces showed excellent conductivity, these inkjet ink compositions did not enable controlled, fine-resolution patterning. The jetting of these inkjet ink compositions was unstable, resulting in very large printed feature sizes and continuous 2D features with a width of around 0.5 mm.

In addition, an inkjet ink has been formulated by dispersing poly(acrylic acid)-capped silver nanoparticles in a mixture of water and ethylene glycol. This is described in the article authored by Qijin Huang, Wenfeng Shen, Qingsong Xu, Ruiqin Tan, Weijie Song: Materials Chemistry and Physics 147 (2014) 550-556. However, the print quality of conductive traces printed by using this inkjet ink composition was poor and many satellite droplets were observed. Indeed, good conductivity was only achieved when many layers of inkjet ink composition were used to produce the conductive traces and thermal sintering at 120°C or above had been performed.

Another silver nanoparticle based inkjet ink formulation, resulted in well-defined printed features having a width of 400 $\mu$m that showed moderate conductivity at room temperatures that was enhanced by thermal sintering at up to 180°C. Details can be found in an article authored by T. ohlund, A. Schuppert, B. Andres, H. Andersson, S. Forsberg, W. Schmidt, H-E. Nilsson, M. Andersson, R. Zhang, H. Olin: 'Assited sintering of silver nanoparticle inkjet ink on paper with active coatings,' (2015) RSC Advances. In a further example, an ink formulation containing silver nanoparticles with an average particle size of 40 nm was inkjet printed to form low resolution patterns (millimetre width), achieving a moderate resistivity of $5.1 \times 10^{-5}$ $\Omega$m after sintering at only 100°C. Further details can be found in an article authored by: L. Cao, X. Bai, Z. Lin, P. Zhang, S. Deng, X. Du, W. Lei: 'The preparation of Ag Nanoparticle and Ink Used for Inkjet Printing of Paper Based Conductive Patterns' (2017) Materials.

A conductive inkjet ink comprising different hydroxy compounds is disclosed US 2007/289483 A1.

The present inventors aimed to produce an ink for printing conductive traces and method of printing it that avoids or at least mitigates at least one of the difficulties described above.

Summary

In an aspect, there is provided an inkjet ink composition for printing conductive traces. The inkjet ink composition comprises:

polymer-capped metal nanoparticles;
a first hydroxy compound, which is a monohydroxyl-substituted hydrocarbon comprising 1 to 6 carbon atoms;
a second hydroxy compound, which is selected from a polyol, a monohydric ether and mixtures thereof; and
water;
wherein the weight ratio of water to first hydroxyl compound is in the range of 1:0.5 to 1:1.5; and
wherein the weight ratio of water to second hydroxy compound is in the range of 1:0.5 to 1:1.5.

In another aspect, there is provided a method of preparing an inkjet ink composition for printing conductive traces. The method for preparing an inkjet ink composition comprises:

combining polymer-capped metal nanoparticles; a first hydroxy compound, which is a monohydroxyl-substituted hydrocarbon comprising 1 to 6 carbon atoms; a second hydroxy compound, which is selected from a polyol, a monohydric ether and mixtures thereof; and water;
wherein the weight ratio of water to first hydroxy compound is in the range of 1:0.5 to 1:1.5; and
wherein the weight ratio of water to second hydroxy compound is in the range of 1:0.5 to 1:1.5.

In a further aspect, there is provided a method of inkjet printing conductive traces, comprising:

jetting an inkjet ink composition onto a surface of a substrate, the inkjet ink composition comprising:

polymer-capped metal nanoparticles;
a first hydroxy compound, which is a monohydroxyl-substituted hydrocarbon comprising 1 to 6 carbon atoms;
a second hydroxy compound, which is selected from a polyol, a monohydric ether and mixtures thereof; and
water,

wherein the weight ratio of water to first hydroxyl compound is in the range of 1:0.5 to 1:1.5; and
wherein the weight ratio of water to second hydroxy compound is in the range of 1:0.5 to 1:1.5.

The inkjet ink composition described herein has been successfully used to produce conductive printed traces with high-resolution features (<100 $\mu$m) by chemically sintering at room temperature (about 20°C). This has enabled conductive traces to be printed on paper, for example, glossy paper, glass and plastic substrates. For example, after room temperature chemical sintering, the resistivity of a single-layer image printed on substrates such as glossy paper was found to be as low as $1.0 \times 10^{-7}$ $\Omega$m, that is, only about 6 times that of bulk silver ($1.59 \times 10^{-8}$ $\Omega$m). Similarly high resolution and conductivity was found when printing on other substrates, such as glass and plastic. Furthermore, the inkjet ink composition jets well from the inkjet print-head nozzle without forming any satellites and results in sharp-edged, high-resolution printed traces without spreading, breaks or cracks. Furthermore, these inkjet ink compositions have been found to be stable over time and therefore displays stable jetting properties. The inventors have also found that the inkjet ink compositions described herein do not require surfactants or other additives to be added to the compositions to stabilise the suspension and create ink compositions that provide high quality printed traces and excellent electrical performance.

The present inventors have found that a combination of the components of the ink in specific relative ratios provides a particularly advantageous combination of surface tension and vapour pressure that enables excellent jetting of the ink composition.

Brief Description of the Figures

Figure 1 shows sequential images of drop formation of silver nanoparticle ink at different intervals of time.

Figure 2 shows inkjet printed conductive traces comprising the chemically sintered inkjet ink composition of Example 1, printed using a) an 80 $\mu$m inkjet print-head nozzle and b) a 50 $\mu$m inkjet print-head nozzle. c) A 2D pattern with a contact pad and the UEA logo were printed on glossy paper with a pixel size of <100 $\mu$m.

Figure 3 shows the relationship between printed line width (a), number of layers printed (b) of the ink composition and resistance.

Figure 4 shows the relationship between (a) printed line width, resistance, resistivity and print pitch and (b) printed line thickness, resistivity and print pitch for inkjet printed conductive traces comprising the chemically sintered inkjet ink composition of Example 2.

Figure 5 shows inkjet printed conductive traces comprising the chemically sintered inkjet ink composition of Example 2, printed using a 50 $\mu$m inkjet print-head nozzle at a print pitch of 55 $\mu$m.

Figure 6 shows the relationship between line thickness, resistivity and print pitch for inkjet printed conductive traces comprising the chemically sintered inkjet ink composition of Example 2.

Figure 7 shows inkjet printed conductive traces comprising the chemically sintered inkjet ink composition of Example 3, printed using a 50 $\mu$m inkjet print-head nozzle at a print pitch of (a) 200 $\mu$m and (b) 55 $\mu$m.

Figure 8 shows the relationship between the mean thickness of a single pass printed line, resistivity and print pitch for inkjet printed conductive traches comprising the chemically sintered inkjet ink composition of Example 3 printed with a 50 $\mu$m inkjet print-head nozzle.

Figure 9 shows inkjet printed conductive traces comprising the chemically sintered inkjet ink composition of Example 4, printed using a 50 $\mu$m inkjet print-head nozzle at a print pitch of (a) 200 $\mu$m and (b) 55 $\mu$m.

Figure 10 shows the relationship between the mean thickness of a single pass printed line, resistivity and print pitch for inkjet printed conductive traces comprising the chemically sintered inkjet ink composition of Example 4 printed with a 50 $\mu$m inkjet print-head

nozzle.

Detailed Description

It will be readily understood that the components of the present invention, as generally described and illustrated in the figures herein, may be arranged and designed in a wide variety of different configurations. Thus, the description of the embodiments of the present invention, as represented in the figures, is not intended to limit the scope of the invention as claimed, but is merely representative of selected embodiments of the invention.
The features, structures or characteristics of the invention described throughout this specification may be combined in any suitable manner in one or more embodiments. For example, the usage of the phrases "examples", "example embodiments", "some embodiments", "embodiments", or similar language throughout this specification refers to the fact that a particular feature, structure or characteristic described in connection with the embodiment may be included in at least one embodiment of the present invention. Thus, appearances of the phrases "in embodiments", "example embodiments", "in some embodiments", "in other embodiments", or other similar language throughout this specification do not necessarily all refer to the same group of embodiments and the described features, structures, or characteristics may be combined in any suitable manner in one or more embodiments.
Embodiments of the present invention provide the previously mentioned aspects, including optional and preferred features of the various aspects as further described below. Unless otherwise stated, any optional or preferred feature may be combined with any other optional or preferred feature, and with any of the aspects of the invention mentioned herein.
It is noted that, as used in this specification and the appended claims, the singular forms "a," "an," and "the" include plural referents unless the context clearly dictates otherwise.
As used herein, "co-polymer" refers to a polymer that is polymerized from at least two monomers.
As used herein, the term "about" is used to provide flexibility to a numerical range endpoint by providing that a given value may be a little above or a little below the endpoint. The degree of flexibility of this term can be dictated by the particular variable.
As used herein, a plurality of items, structural elements, compositional elements, and/or materials may be presented in a common list for convenience. However, these lists should be construed as though each member of the list is individually identified as a separate and unique member. Thus, no individual member of such a list should be construed as a de facto equivalent of any other member of the same list solely based on their presentation in a common group without indications to the contrary.
Concentrations, amounts, and other numerical data may be expressed or presented herein in a range format. It is to be understood that such a range format is used merely for convenience and brevity and thus should be interpreted flexibly to include not just the numerical values explicitly recited as the end points of the range, but also to include all the individual numerical values or sub-ranges encompassed within that range as if each numerical value and sub-range is explicitly recited. As an illustration, a numerical range of "about 1 wt.% to about 5 wt.%" should be interpreted to include not just the explicitly recited values of about 1 wt.% to about 5 wt.%, but also include individual values and subranges within the indicated range. Thus, included in this numerical range are individual values such as 2, 3.5, and 4 and sub-ranges such as from 1-3, from 2-4, and from 3-5, and the like. This same principle applies to ranges reciting a single numerical value. Furthermore, such an interpretation should apply regardless of the breadth of the range or the characteristics being described.

As used herein, unless specified otherwise, wt.% values are to be taken as referring to a weight-for-weight (w/w) percentage.

Unless otherwise stated, any feature described herein can be combined with any aspect or any other feature described herein.

*Inkjet ink composition*

In an aspect, there is provided an inkjet ink composition for printing conductive traces. The inkjet ink composition may comprise polymer-capped metal nanoparticles; a first hydroxy compound, which is a monohydroxyl-substituted hydrocarbon comprising 1 to 6 carbon atoms; a second hydroxy compound, which is selected from a polyol, a monohydric ether and mixtures thereof; and water, wherein the weight ratio of water to first hydroxy compound is in the range of 1:0.5 to 1:1.5; and wherein the weight ratio of water to second hydroxy compound is in the range of 1:0.5 to 1:1.5.

In some examples, the weight ratio of water to first hydroxy compound is in the range of about 1:0.5 to about 1:1.5. In some examples, the weight ratio of water to first hydroxy compound is in the range of about 1:0.55 to about 1:1.4, for example, about 1:0.6 to about 1:1.3, about 1:0.65 to about 1:1.2, about 1:0.7 to about 1:1.1, about 1:0.75 to about 1:1, about 1:0.8 to about 1:1, about 1:0.5 to about 1:0.95, about 1:0.55 to about 1:0.9, about 1:0.6 to about 1:0.85, about 1:0.65 to about 1:0.8. In some examples, the weight ratio of water to first hydroxy compound may be about 1:0.8.

In some examples, the weight ratio of water to second hydroxy compound is in the range of about 1:0.5 to about 1:1.5. In some examples, the weight ratio of water to second hydroxy compound is in the range of about 1:0.55 to about 1:1.4, for example, about 1:0.6 to about 1:1.3, about 1:0.65 to about 1:1.2, about 1:0.7 to about 1:1.1, about 1:0.75 to about 1:1, about 1:0.8 to about 1:1, about 1:0.85 to about 1:1.05, about 1:0.9 to about 1:1, about 1:0.5 to about 1:0.95, about 1:0.5 to about 1:0.9. In some examples, the weight ratio of water to second hydroxy compound may be about 1:0.9.

In some examples, the weight ratio of water to first hydroxy compound is in the range of about 1:0.55 to about 1:1.4, for example, about 1:0.6 to about 1:1.3, about 1:0.65 to about 1:1.2, about 1:0.7 to about 1:1.1, about 1:0.75 to about 1:1, about 1:0.8 to about 1:1, about 1:0.5 to about 1:0.95, about 1:0.55 to about 1:0.9, about 1:0.6 to about 1:0.85, about 1:0.65 to about 1:0.8 and the weight ratio of water to second hydroxy compound is in the range of about 1:0.55 to about 1:1.4, for example, about 1:0.6 to about 1:1.3, about 1:0.65 to about 1:1.2, about 1:0.7 to about 1:1.1, about 1:0.75 to about 1:1, about 1:0.8 to about 1:1, about 1:0.85 to about 1:1.05, about 1:0.9 to about 1:1, about 1:0.5 to about 1:0.95, about 1:0.5 to about 1:0.9.

In some examples, the weight ratio of water to first hydroxy compound may be about 1:0.8 and the weight ratio of water to second hydroxy compound may be about 1:0.9. In some examples, the weight ratio of water to first hydroxy compound may be about 1:0.5 and the weight ratio of water to second hydroxy compound may be about 1:0.5. In some examples, the weight ratio of water to first hydroxy compound may be about 1:1.5 and the ratio of water to second hydroxy compound may be about 1:0.5. In some examples, the weight ratio of water to first hydroxy compound may be about 1:0.5 and the weight ratio of water to second hydroxy compound may be about 1:1.5.

In some examples, the water, first hydroxy compound and second hydroxy compound constitute a total of at least 10 wt.% of the inkjet ink composition, for example, at least 20 wt.%, at least 25 wt.%, at least 30 wt.%, at least 35 wt.%, at least 40 wt.%, at least 45 wt.%, at least 50 wt.%, at least 55 wt.%, at least 60 wt.%, at least 65 wt.%, at least 70 wt.%, at least 75 wt.%, at least 80 wt.%, at least 85 wt.%, or at least 90 wt.% of the inkjet ink composition. In some examples, the water, first hydroxy compound and second hydroxyl compound constitute a total of 90 wt.% or less of the inkjet ink composition, for example, 85 wt.% or less, 80 wt.% or less, 75 wt.% or less, 70 wt.% or less, 65 wt.% or less, 60 wt.% or less, 55 wt.% or less, 50 wt.% or less, 45 wt.% or less, 40 wt.% or less, 35 wt.% or less, 30 wt.% or less, 25 wt.% or less, 20 wt.% or less, 15 wt.% or less, or 10 wt.% or less of the inkjet ink composition. In some examples, the water, first hydroxyl compound and second hydroxy compound constitute a total of from 10 wt.% to 90 wt.% of the inkjet ink composition, for example, 15 wt.% to 85 wt.%, 20 wt.% to 80 wt.%, 25 wt. % to 75 wt. %, 30 wt. % to 90 wt. %, 35 wt.% to 85 wt. %, 40 wt. % to 80 wt. %, 45 wt. % to 75 wt. %, 50 wt. % to 70 wt. %, 55 wt. % to 90 wt. %, 60 wt. % to 85 wt. %, 65 wt. % to 80 wt.%, 70 wt.% to 90 wt.% of the inkjet ink composition.

In some examples, the inkjet ink composition has a dynamic viscosity of from 1 mPa·s to 20 mPa s, optionally from 1 mPa·s to 15 mPa s, optionally from 3 mPa·s to 15 mPa s, optionally from 3 mPa·s to 10 mPa s, optionally from 5 mPa·s to 10 mPa s, optionally from 6 mPa·s to 8 mPa s, optionally about 7 mPa s. The dynamic viscosity was measured with a rheometer, for example, an AR2000 rheometer provided by TA Instruments, at 25°C by using a 60 mm 1° spindle at a shear rate of 0.1 to 1000/sec.

In some examples, the inkjet ink composition has a surface tension in the range of 23 dynes/cm to 30 dynes/cm, for example, 23.5 dynes/cm to 29.5 dynes/cm, 24 dynes/cm to 29 dynes/cm, 24.5 dynes/cm to 28.5 dynes/cm, 25 dynes/cm to 28 dynes/cm, 25.5 dynes/cm to 27.5 dynes/cm, 26 dynes/cm to 27 dynes/cm, 26.5 dynes/cm to 30 dynes/cm, 27 dynes/cm to 30 dynes/cm, or about 27.1 dynes/cm. The surface tension was measured by using a tensiometer, for example, a One Attension Theta Optical Tensiometer provided by Biolin Scientific.

In some examples, the inkjet ink composition has a density in the range of 1.1 $g/cm^3$ to 1.46 $g/cm^3$, for example, 1.11 $g/cm^3$ to 1.45 $g/cm^3$, 1.12 $g/cm^3$ to 1.44 $g/cm^3$, 1.13 $g/cm^3$ to 1.43 $g/cm^3$, 1.14 $g/cm^3$ to 1.42 $g/cm^3$, 1.15 $g/cm^3$ to 1.41 $g/cm^3$, 1.16 $g/cm^3$ to 1.40 $g/cm^3$, 1.17 $g/cm^3$ to 1.39 $g/cm^3$, 1.18 $g/cm^3$ to 1.38 $g/cm^3$, 1.19 $g/cm^3$ to 1.37 $g/cm^3$, 1.2 $g/cm^3$ to 1.36 $g/cm^3$, 1.21 $g/cm^3$ to 1.35 $g/cm^3$, 1.22 $g/cm^3$ to 1.34 $g/cm^3$, 1.23 $g/cm^3$ to 1.32 $g/cm^3$, 1.24 $g/cm^3$ to 1.31 $g/cm^3$, 1.25 $g/cm^3$ to 1.30 $g/cm^3$, 1.26 $g/cm^3$ to 1.29 $g/cm^3$, 1.27 $g/cm^3$ to 1.28 $g/cm^3$, 1.28 $g/cm^3$ to 1.46 $g/cm^3$.

*Water*

In some examples, water is selected from tap water, mineral water, spring water, purified water, deionised water and distilled water.

In some examples, water constitutes at least 10 wt.%, at least 11 wt.%, at least 12 wt.%, at least 13 wt.%, or at least 14 wt.% at least 15 wt.%, at least 16 wt.%, at least 17 wt.%, at least 18 wt.%, at least 19 wt.%, at least 20 wt.%, at least 21 wt.%, at least 22 wt.%, at least 23 wt.%, at least 24 wt.%, at least 25 wt.%, at least 26 wt.% of the inkjet ink composition. In some examples, water constitutes 35 wt.% or less, 34 wt.% or less, 33 wt.% or less, 32 wt.% or less, 31 wt.% or less, 30 wt.% or less, 29 wt.% or less, 28 wt.% or less, 27 wt.% or less, or 26 wt.% or less of the inkjet ink composition. In some examples, water constitutes 10 wt.% to 35 wt.%, 11 wt. % to 34 wt. %, 12 wt.% to 33 wt.%, 13 wt.% to 32 wt.%, 14 wt.% to 31 wt.%, 15 wt.% to 30 wt.%, 15 wt.% to 29 wt.%, 15 wt.% to 28 wt.%, 17 wt.% to 27 wt.%, 18 wt.% to 26 wt.%, 19 wt.% to 35 wt.%, 20 wt.% to 34 wt.%, 21 wt.% to 33 wt.%, 22 wt.% to 32 wt.%, 23 wt.% to 31 wt.%, 24 wt.% to 30 wt.%, 25 wt.% to 29 wt.%, 26 wt.% to 28 wt.% of the inkjet ink composition.

*First hydroxy compound*

In some examples, the first hydroxy compound is a monohydroxyl-substituted hydrocarbon comprising 1 to 6 carbon atoms. In some examples, the monohydroxyl-substituted hydrocarbon comprising 1 to 6 carbon atoms is a straight chain hydrocarbon, branched chain hydrocarbon or cyclic hydrocarbon. In some examples, the monohydroxyl-substituted hydrocarbon comprises 1, 2, 3, 4, 5 or 6 carbon atoms. In some examples, the monohydroxyl-substituted hydrocarbon comprises 3 to 6 carbon atoms. In some examples, the monohydroxyl-substituted hydrocarbon comprises 3 carbon atoms.

In some examples, the first hydroxy compound comprises one monohydroxyl-substituted hydrocarbon comprising 1 to 6 carbon atoms. In some examples, the first hydroxy compound comprises a mixture of monohydroxyl-substituted hydrocarbons comprising 1 to 6 carbon atoms.

In some examples, the first hydroxy compound is selected from methanol, ethanol, 1-propanol, isopropanol, any isomer of butanol, pentanol, hexanol and mixtures thereof. In some examples, the isomer of butanol is selected from 1-butanol, 2-butanol and isobutanol.

In some examples, the first hydroxyl compound constitutes at least 10 wt.%, at least 11 wt.%, at least 12 wt.%, at least 13 wt.%, at least 14 wt.%, at least 15 wt.%, at least 16 wt.%, at least 17 wt.%, at least 18 wt.%, at least 19 wt.%, or at least 20 wt.% of the inkjet ink composition. In some examples, the first hydroxyl compound constitutes 35 wt.% or less, 34 wt.% or less, 33 wt.% or less, 32 wt.% or less, 31 wt.% or less, 30 wt.% or less, 29 wt.% or less, 28 wt.% or less, 27 wt.% or less, 26 wt.% or less, 25 wt.% or less, 24 wt.% or less, 23 wt.% or less, 22 wt.% or less, 21 wt.% or less, or 20 wt.% or less of the inkjet ink composition. In some examples, the first hydroxy compound constitutes 10 wt.% to 35 wt.%, 11 wt.% to 34 wt.%, 12 wt.% to 33 wt.%, 13 wt.% to 32 wt.%, 14 wt.% to 31 wt.%, 15 wt.% to 30 wt.%, 16 wt.% to 29 wt. %, 17 wt.% to 28 wt.%, 18 wt.% to 27 wt.%, 19 wt.% to 26 wt.%, 20 wt.% to 25 wt.%, 10 wt. % to 24 wt.%, 11 wt.% to 23 wt.%, 12 wt.% to 22 wt.%, 13 wt.% to 21 wt.%, 14 wt.% to 20 wt.% of the inkjet ink composition.

*Second hydroxy compound*

In some examples, the second hydroxy compound is selected from a polyol, a monohydric ether and mixtures thereof. In some examples, the second hydroxy compound is selected from a polyol and a monohydric ether. In some examples, the second hydroxy compound is a polyol. In some examples, the second hydroxy compound is a monohydric ether.

As used herein, the term polyol indicates a compound containing at least two hydroxy groups.

In some examples, the polyol is selected from compounds comprising 2, 3, 4, or 5 alcohol groups. In some examples, the polyol is a diol or a triol. In some examples, the polyol is a diol.

In some examples, the polyol comprises 1 to 100 carbon atoms, for example, 1 to 50 carbon atoms, 1 to 25 carbon atoms, 1 to 10 carbon atoms, 1 to 5 carbon atoms.

In some examples, the polyol is selected from methanediol, ethanediol (e.g., ethylene glycol), propanediol (e.g., propylene glycol), butanediol (e.g., butylene glycol), pentanediol (e.g., pentylene glycol), hexanediol (e.g., 1,2-hexanediol and hexylene glycol), diethylene glycol, dipropylene glycol, dibutylene glycol, dipentylene glycol, dihexylene glycol, triethylene glycol, tripropylene glycol, tributylene glycol, tripentylene glycol, trihexylene glycol, poly(ethylene glycol) having a molecular weight of 1000 or less, glycerol, triethanolamine. In some examples, the polyol is selected from ethylene glycol, diethylene glycol, triethylene glycol, propylene glycol, poly(ethylene glycol) having a molecular weight of 1000 or less, and glycerol. In some examples, the polyol is ethylene glycol.

As used herein, the term monohydric ether refers to compounds containing one hydroxyl group and at least one ether.

In some examples, the monohydric ether comprises 1 to 100 carbon atoms, for example, 1 to 50 carbon atoms, 1 to 25 carbon atoms, 1 to 10 carbon atoms, 1 to 5 carbon atoms.

In some examples, the monohydric ether is selected from monoalkyl ethers of ethylene glycol, diethylene glycol, triethylene glycol, propylene glycol, poly(ethylene glycol) having a molecular weight of 1000 or less, and glycerol. In some examples, the monoalkyl ether is selected from monomethyl ethers, monoethyl ethers, monobutyl ethers, monopropyl ethers. In some examples, the monohydric ether is selected from triethylene glycol monomethyl ether, triethylene glycol monobutyl ether, triethylene glycol monoethyl ether, diethylene glycol monoethyl ether, diethylene glycol monobutyl ether, ethylene glycol monopropyl ether, dipropylene glycol monomethyl ether.

In some examples, the second hydroxyl compound constitutes at least 10 wt.%, at least 11 wt.%, at least 12 wt.%, at least 13 wt.%, at least 14 wt.%, at least 15 wt.%, at least 16 wt.%, at least 17 wt.%, at least 18 wt.%, at least 19 wt.%, at least 20 wt.%, at least 21 wt.%, at least 22 wt.%, at least 23 wt.%, or at least 24 wt.% of the inkjet ink composition. In some examples, the first hydroxyl compound constitutes 35 wt.% or less, 34 wt.% or less, 33 wt.% or less, 32 wt.% or less, 31 wt.% or less, 30 wt.% or less, 29 wt.% or less, 28 wt.% or less, 27 wt.% or less, 26 wt.% or less, 25 wt.% or less, 24 wt.% or less, 23 wt.% or less of the inkjet ink composition. In some examples, the first hydroxy compound constitutes 10 wt.% to 35 wt.%, 11 wt.% to 34 wt.%, 12 wt.% to 33 wt.%, 13 wt.% to 32 wt. %, 14 wt. % to 31 wt.%, 15 wt. % to 30 wt. %, 16 wt. % 29 wt. %, 17 wt. % to 28 wt. %, 18 wt.% to 27 wt.%, 19 wt.% to 26 wt.%, 20 wt.% to 25 wt.%, 21 wt.% to 24 wt.%, 22 wt.% to 23 wt.%, 23 wt.% to 35 wt.% of the inkjet ink composition.

*Polymer-capped metal nanoparticles*

In some examples, the polymer-capped metal nanoparticles may be any polymer-capped metal nanoparticles capable of being chemically sintered. In some examples, the polymer-capped metal nanoparticles may be any polymer-capped metal nanoparticles capable of being chemically sintered at room temperature, i.e., a temperature of from 20°C to 25°C. In some examples, the polymer-capped metal nanoparticles may be any polymer-capped metal nanoparticles capable of being chemically sintered at room temperature by application of a sintering agent. Chemical sintering causes the polymer capping agent to be detached from the metal nanoparticles, allowing the metal nanoparticles to coagulate and/or fuse together.

In some examples, the polymer-capped metal nanoparticles may be particles having a diameter of 100 nm or less, for example, 95 nm or less, 90 nm or less, 85 nm or less, 80 nm or less, 75 nm or less, 70 nm or less, 65 nm or less, 60 nm or less, 55 nm or less, 50 nm or less, 45 nm or less, 40 nm or less, 35 nm or less, 30 nm or less, 29 nm or less, 28 nm or less, 27 nm or less, 26 nm or less, 25 nm or less, 24 nm or less, 23 nm or less, 22 nm or less, 21 nm or less, or 20 nm or less. In some examples, the polymer-capped metal nanoparticles may be particles having a diameter of 1 nm or more, for example, 15 nm or more, 10 nm or more, 9 nm or more, 8 nm or more, 7 nm or more, 6 nm or more, 5 nm or more, 4 nm or more, 3 nm or more, or 2 nm or more. In some examples, the polymer-capped metal nanoparticles may be particles having diameter of 1 nm to 100 nm, for example, 1 nm to 65 nm, 5 nm to 65 nm, 10 nm to 65 nm, 15 nm to 65 nm, 1 nm to 50 nm, 1 nm to 40 nm, 1 nm to 30 nm, 1 nm to 25 nm, 1 nm to 20 nm. In the present context, the diameter of the particles being a particular size indicates that at least some of the particles are that size. The diameter may be measured by any suitable method, for example, by TEM.

In some examples, the polymer-capped metal nanoparticles have a mean diameter of 100 nm or less, for example, 95 nm or less, 90 nm or less, 85 nm or less, 80 nm or less, 75 nm or less, 70 nm or less, 65 nm or less, 60 nm or less, 55 nm or less, 50 nm or less, 45 nm or less, 40 nm or less, 35 nm or less, 30 nm or less, 29 nm or less, 28 nm or less, 27 nm or less, 26 nm or less, 25 nm or less, 24 nm or less, 23 nm or less, 22 nm or less, 21 nm or less, or 20 nm or less. In some examples, the polymer-capped metal nanoparticles have a mean diameter of 1 nm or more, for example, 15 nm or more, 10 nm or more, 9 nm or more, 8 nm or more, 7 nm or more, 6 nm or more, 5 nm or more, 4 nm or more, 3 nm or more, or 2 nm or more. In some examples, the polymer-capped metal nanoparticles have a mean diameter of 1 nm to 100 nm, for example, 1 nm to 65 nm, 5 nm to 65 nm, 10 nm to 65 nm, 15 nm to 65 nm, 1 nm to 50 nm, 1 nm to 40 nm, 1 nm to 30 nm, 1 nm to 25 nm, 1 nm to 20 nm. Mean diameter may be determined, for example, by transmission electron microscopy (TEM), for example, by taking a sample of the polymer-capped metal nanoparticles and measuring the diameter (using a transmission electron microscope) of each of N nanoparticles, where N is 50 or more, summing the diameters for all N nanoparticles, and then dividing the sum of the diameters by N. Mean diameter may be the mean diameter by volume determined, for example, by dynamic light scattering (DLS) and may be termed the $D_{50}$.

In some examples, the polymer capping agent may be any polymer capable of being detached from the metal nanoparticles during room temperature sintering. In some examples, the polymer capping agent may be any polymer capable of being detached from the metal nanoparticles by a sintering agent at low temperature (e.g., 50°C or less). In some examples, the polymer capping agent may be any polymer capable of being detached from the metal nanoparticles by a sintering agent at low temperature to form a conductive trace. The detachment of the polymer capping agent from the metal nanoparticles causes the metal nanoparticles to coagulate and/or fuse together. The low temperature may be a temperature of about 50°C or less, for example, 25°C or less. In some examples, the low temperature may be room temperature, i.e., from about 20°C to about 25°C.

In some examples, the polymer capping agent is a polymer of a carboxylic acid or a polymer of an amide containing monomer. In some examples, the polymer capping agent is selected from poly(acrylic acid), poly(vinyl pyrrolidone), poly(maleic acid), poly(methacrylic acid), poly(acrylic acid-co-methacrylic acid), poly(maleic acid-co-acrylic acid), poly(acrylamide-co-acrylic acid), poly[hydroxylethyl(meth)acrylate-co-(meth)-acrylic acid], poly[hydroxypropyl(meth)acrylate-co-(meth)acrylic acid], and poly(methyl methacrylate). In some examples, the polymer capping agent is selected from poly(acrylic acid), poly(vinyl pyrrolidone), poly(maleic acid), poly(methacrylic acid), poly(acrylic acid-co-methacrylic acid), poly(maleic acid-co-acrylic acid), poly(acrylamide-co-acrylic acid), poly[hydroxylethyl(meth)acrylate-co-(meth)acrylic acid] and poly-[hydroxypropyl(meth)acrylate-co-(meth)acrylic acid]. In some examples, the polymer capping agent may be selected from poly(acrylic acid) and poly(vinyl pyrrolidone). In some examples, the polymer capping agent may be poly(acrylic acid).

The term (meth)acrylic acid refers to a monomer selected from acrylic acid and methacrylic acid. The term (meth)acrylate refers to a monomer selected from acrylate and methacrylate.

In some examples, the metal nanoparticles may be nanoparticles of one metal, alloy nanoparticles, or core-shell nanoparticles.

In some examples, the metal is selected from silver, copper, gold, nickel, palladium, platinum, and mixtures thereof. In some examples, the metal may be an alloy, which may be selected from silver-copper alloys and silver-palladium alloys. In some examples, the metal is selected from silver, copper and gold. In some examples, the metal is silver.

In some examples, the polymer-capped metal nanoparticles may be selected from poly(acrylic acid)-capped silver nanoparticles, poly(acrylic acid)-capped copper nanoparticles, poly(acrylic acid)-capped gold nanoparticles, poly(vinyl pyrrolidone)-capped silver nanoparticles, poly(vinyl pyrrolidone)-capped copper nanoparticles and poly(vinyl pyrrolidone)-capped gold nanoparticles. In some examples, the polymer-capped metal nanoparticles may be selected from poly(acrylic acid)-capped silver nanoparticles, poly(acrylic acid)-capped copper nanoparticles and poly(acrylic acid)-capped gold nanoparticles. In some examples, the polymer-capped metal nanoparticles may be selected from poly(acrylic acid)-capped silver nanoparticles and poly(vinyl pyrrolidone)-capped silver nanoparticles. In some examples, the polymer-capped metal nanoparticles may be poly(acrylic acid)-capped silver nanoparticles.

In some examples, the inkjet ink composition may comprise at least 10 wt.% polymer-capped metal nanoparticles, for example, at least 15 wt.%, at least 20 wt.%, at least 25 wt.%, at least 30 wt.%, at least 35 wt.%, at least 40 wt.%, at least 45 wt.%, at least 50 wt.%, at least 55 wt.%, at least 60 wt.%, at least 65 wt.%, at least 70 wt.%, at least 75 wt.%, or at least 80 wt.% polymer-capped metal nanoparticles. In some examples, the inkjet ink composition may comprise 80 wt.% or less polymer-capped metal nanoparticles, for example, 75 wt.% or less, 70 wt.% or less, 65 wt.% or less, 60 wt.% or less, 55 wt.% or less, 50 wt.% or less, 45 wt.% or less, 40 wt.% or less, 35 wt.% or less, 30 wt.% or less, 25 wt.% or less, 20 wt.% or less, 15 wt.% or less, or 10 wt.% or less polymer-capped metal nanoparticles. In some examples, the inkjet ink composition may comprise 10 wt.% to 80 wt.% polymer-capped metal nanoparticles, for example, 15 wt.% to 75 wt. %, 20 wt.% to 70 wt. %, 25 wt.% to 65 wt.%, 30 wt. % to 60 wt. %, 10 wt.% to 55 wt.%, 15 wt.% to 50 wt.%, 20 wt.% to 45 wt.%, 25 wt.% to 40 wt.%, 30 wt.% to 35 wt.%, 10 wt. % to 30 wt. % polymer-capped metal nanoparticles. In some examples, the balance of the inkjet ink composition comprises water, first hydroxy compound and second hydroxy compound.

*Method of preparing an inkjet ink composition*

In an aspect, there is provided a method of preparing an inkjet ink composition for printing conductive traces. The method of preparing an inkjet ink composition may comprise combining polymer-capped metal nanoparticles, a first hydroxy compound, which is a monohydroxyl-substituted hydrocarbon comprising 1 to 6 carbon atoms; a second hydroxy compound, which is selected from a polyol, a monohydric ether and mixtures thereof; and water; wherein the weight ratio of water to first hydroxy compound is in the range of 1:0.5 to 1:1.5; and wherein the weight ratio of water to second hydroxy compound is in the range of 1:0.5 to 1:1.5.

In some examples, the polymer-capped metal nanoparticles are combined with the second hydroxy compound and water prior to being combined with the first hydroxy compound. In some examples, the polymer-capped metal nanoparticles are combined with the second hydroxy compound and water and sonicated prior to the addition of the first hydroxy compound. In some examples, the mixture is sonicated for at least 5 min, at least 10 min, at least 15 min, at least 20 min, at least 25 min, or at least 30 min. In some examples, the mixture is sonicated for 60 min or less, 55 min or less, 50 min or less, 45 min or less, 40 min or less, 35 min or less, or 30 min or less. In some examples, the mixture is sonicated for from 5 min to 60 min, 10 min to 55 min, 15 min to 50 min, 20 min to 45 min, 25 min to 40 min, 30 min to 35 min, or 5 min to 30 min.

In some examples, after addition of the first hydroxy compound, the mixture is stirred. In some examples, the mixture is stirred for at least 1 min, at least 1.5 min, at least 2 min, at least 2.5 min, at least 3 min, at least 3.5 min, at least 4 min, at least 4.5 min, at least 5 min, at least 5.5 min, at least 6 min, at least 6.5 min, at least 7 min, at least 7.5 min, at least 8 min, at least 8.5 min, at least 9 min, at least 9.5 min, or at least 10 min. In some examples, the mixture is stirred for 20 min or less, 19.5 min or less, 19 min or less, 18.5 min or less, 18 min or less, 17.5 min or less, 17 min or less, 16.5 min or less, 16 min or less, 15.5 min or less, 15 min or less, 14.5 min or less, 14 min or less, 13.5 min or less, 13 min or less, 12.5 min or less, 12 min or less, 11.5 min or less, 11 min or less, 10.5 min or less, or 10 min or less. In some examples, the mixture is stirred for 1 min to 20 min, 1.5 min to 19.5 min, 2 min to 19 min, 2.5 min to 18.5 min, 3 min to 18 min, 3.5 min to 17.5 min, 4 min to 17 min, 4.5 min to 16.5 min, 5 min to 16 min, 5.5 min to 15.5 min, 6 min to 15 min, 6.5 min to 14.5 min, 7 min to 14 min, 7.5 min to 13 min, 8 min to 12.5 min, 8.5 min to 12 min, 9 min to 11.5 min, 9.5 min to 11 min, 10 min to 10.5 min, or 1 min to 10 min.

In some examples, the polymer-capped metal nanoparticles are synthesised by combining a polymer with a metal salt in the presence of a base, for example, a strong base. In some examples, the metal salt is a metal nitrate. In some examples, the strong base is triethanolamine.

In some examples, the mixture of the polymer, metal salt and base is heated, for example, to at least 50°C, for example, at least 55°C, at least 60°C, at least 65°C, or at least 70°C. In some examples, the mixture of the polymer, metal salt and base is heated, for example, for at least 1 h, for example, at least 1.5 h, at least 2 h, at least 2.5 h, or at least 3 h. Once the mixture has cooled, it may be sonicated, for example, for at least 10 min, for example, at least 15 min, at least 20 min, at least 25 min, at least 30 min, at least 35 min, at least 40 min, at least 45 min, at least 50 min, at least 55 min, or at least 60 min. In some examples, the obtained polymer-capped metal nanoparticles may be washed with an alcohol, for example, by centrifugation. In some examples, the obtained polymer-capped metal nanoparticles may be washed at least twice, for example, at least three times, at least 4 times, or at least 5 times. In some examples, the obtained polymer-capped metal nanoparticles may be washed four to five times, for example, by centrifugation. In some examples, the washed polymer-capped metal nanoparticles may be dried, for example, by heating prior to incorporation into the inkjet ink composition.

*Method of inkjet printing conductive traces*

In an aspect, there is provided a method of inkjet printing conductive traces. The method of inkjet printing conductive traces may comprise jetting an inkjet ink composition onto a surface of a substrate. The inkjet ink composition may be an inkjet ink composition as described above.

In some examples, the method of inkjet printing conductive traces may comprise jetting an inkjet ink composition onto a surface of a substrate, the inkjet ink composition comprising polymer-capped metal nanoparticles; a first hydroxy compound, which is a monohydroxyl-substituted hydrocarbon comprising 1 to 6 carbon atoms; a second hydroxy compound, which is selected from a polyol, a monohydric ether and mixtures thereof; and water, wherein the weight ratio of water to first hydroxyl compound is in the range of 1:0.5 to 1:1.5; and wherein the weight ratio of water to second hydroxy compound is in the range of 1:0.5 to 1:1.5.

In some examples, once the inkjet ink composition contacts the surface of the substrate, the polymer-capped metal nanoparticles are sintered to form the conductive trace. In some examples, the sintering occurs at a temperature of 50°C or less, for example, 45°C or less, 40°C or less, 35°C or less, 30°C or less, 25°C or less, or 20°C or less. In some examples, the sintering occurs at a temperature of 5°C or more, for example, 10°C or more, 15°C or more, 18°C or more, or 20°C or more. In some examples, the sintering occurs at a temperature of 5°C to 50°C, for example, 10°C to 45°C, 15°C to 40°C, 18°C to 35°C, 20°C to 30°C, 5°C to 25°C. In some examples, the sintering occurs at room temperature. In some examples, the sintering occurs without heating being required.

Sintering may cause the detachment of the polymer capping agent from the metal nanoparticles, allowing the metal nanoparticles to fuse together. Chemical sintering may cause the polymer capping agent to be detached from the metal nanoparticles, allowing the metal nanoparticles to fuse together. The fusing of the metal nanoparticles may create the conductive trace.

In some examples, the polymer-capped metal nanoparticles are chemically sintered. In some examples, the polymer-capped metal nanoparticles are chemically sintered by being contacted with a sintering agent.

In some examples, the surface of the substrate comprises a sintering agent. In some examples, a sintering agent is applied to the printed inkjet ink composition after the inkjet ink composition is jetted onto the surface of the substrate.

The sintering agent may be any agent capable of detaching the polymer capping agent from the metal nanoparticles. In some examples, the sintering agent may be any agent capable of detaching the polymer capping agent from the metal nanoparticles at room temperature. In some examples, the sintering agent may be any agent capable of detaching the polymer capping agent from the metal nanoparticles at a temperature of 50°C or less.

In some examples, the sintering agent may be a salt. In some examples, the sintering agent may be an inorganic salt or an organic salt. In some examples, the sintering agent may comprise halide ions, for example, chloride ions. In some examples, the sintering agent may comprise KCl, NaCl, $MgCl_2$, $AlCl_3$, LiCl, $CaCl_2$, HCl or a chloride containing polymer, such as poly(diallyldimethylammonium chloride) (PDAC). In some examples, the sintering agent may comprise dilute HCl, which may be a 0.1 M solution in water. In some examples, the sintering agent may be HCl vapour.

In some examples, after sintering, the inkjet ink composition has a resistivity of $3\times10^{-7}$ $\Omega$m or less, for example, $2.9\times10^{-7}$ $\Omega$m or less, $2.8\times10^{-7}$ $\Omega$m or less, $2.7\times10^{-7}$ $\Omega$m or less, $2.6\times10^{-7}$ $\Omega$m or less, $2.5\times10^{-7}$ $\Omega$m or less, $2.4\times10^{-7}$ $\Omega$m or less, $2.3\times10^{-7}$ $\Omega$m or less, $2.2\times10^{-7}$ $\Omega$m or less, $2.1\times10^{-7}$ $\Omega$m or less, $2\times10^{-7}$ $\Omega$m or less, $1.5\times10^{-7}$ $\Omega$m or less, $1\times10^{-7}$ $\Omega$m or less, $9\times10^{-8}$ $\Omega$m or less, $8.9\times10^{-8}$ $\Omega$m or less, $8.8\times10^{-8}$ $\Omega$m or less, $8.7\times10^{-8}$ $\Omega$m or less, $8.6\times10^{-8}$ $\Omega$m or less, $8.5\times10^{-8}$ $\Omega$m or less, or $8.4\times10^{-8}$ $\Omega$m or less. In some examples, after sintering, the inkjet ink composition has a resistivity of $7.5\times10^{-8}$ $\Omega$m to $3\times10^{-7}$ $\Omega$m, for example, $7.6\times10^{-8}$ $\Omega$m to $2.9\times10^{-7}$ $\Omega$m, $7.7\times10^{-8}$ $\Omega$m to $2.8\times10^{-7}$ $\Omega$m, $7.8\times10^{-8}$ $\Omega$m to $2.7\times10^{-7}$ $\Omega$m, $7.9\times10^{-8}$ $\Omega$m to $2.6\times10^{-7}$ $\Omega$m, $8\times10^{-8}$ $\Omega$m to $2.5\times10^{-7}$ $\Omega$m, $8.1\times10^{-8}$ $\Omega$m to $2.4\times10^{-7}$ $\Omega$m, $8.2\times10^{-8}$ $\Omega$m to $2.3\times10^{-7}$ $\Omega$m, $8.3\times10^{-8}$ $\Omega$m to $2.2\times10^{-7}$ $\Omega$m, $8.4\times10^{-8}$ $\Omega$m to $2.1\times10^{-7}$ $\Omega$m, $8.5\times10^{-8}$ $\Omega$m to $2\times10^{-7}$ $\Omega$m, $8.6\times10^{-8}$ to $1.9\times10^{-7}$ $\Omega$m. $8.7\times10^{-8}$ $\Omega$m to $1.8\times10^{-7}$ $\Omega$m, $8.8\times10^{-8}$ $\Omega$m to $1.7\times10^{-7}$ $\Omega$m, $8.9\times10^{-8}$ $\Omega$m to $1.6\times10^{-7}$ $\Omega$m, $9\times10^{-8}$ $\Omega$m to $1.5\times10^{-7}$ $\Omega$m, $1\times10^{-7}$ $\Omega$m to $1.4\times10^{-7}$ $\Omega$m, $1.1\times10^{-7}$ $\Omega$m to $1.3\times10^{-7}$ $\Omega$m, $1.2\times10^{-7}$ $\Omega$m to $2.5\times10^{-7}$ $\Omega$m, or $1\times10^{-7}$ $\Omega$m to $2.5\times10^{-7}$ $\Omega$m. In some examples, after sintering, the inkjet ink composition has a resistivity of less than 6 times that of bulk silver ($1.59\times10^{-8}\Omega$m), for example, less than 5.9 times that of bulk silver, less than 5.8 times that of bulk silver, less than 5.7 times that of bulk silver, less than 5.6 times that of bulk silver, less than 5.5 times that of bulk silver, less than 5.4 times of that bulk silver, or less than 5.3 times of that bulk silver.

In some examples, after sintering, the inkjet ink composition has a conductivity of at least $4\times10^1$ S/m, for example, at least $4.1 \times 10^6$ S/m, at least $4.2 \times 10^6$ S/m, at least $4.3\times 10^6$ S/m, at least $4.4\times10^6$ S/m, at least $4.5\times10^6$ S/m, at least $4.6\times10^6$ S/m, at least $4.7\times10^6$ S/m, at least $4.8\times10^6$ S/m, at least $4.9\times10^6$ S/m, at least $0.5\times10^7$ S/m, at least $0.6\times10^7$ S/m, at least $0.7\times10^7$ S/m, at least $0.8\times10^7$ S/m, at least $0.9\times10^7$ S/m, at least $1\times10^7$ S/m, or at least $1.1\times10^7$ S/m. In some examples, after sintering, the inkjet ink composition has a conductivity of $4\times10^6$ S/m to $1.6\times10^7$ S/m, for example, $4.1\times10^6$ S/m to $1.5\times10^7$ S/m, $4.2\times10^6$ S/m to $1.4\times10^7$ S/m, $4.3\times10^6$ S/m to $1.3\times10^7$ S/m, $4.4\times10^6$ S/m to $1.2\times10^7$ S/m, $4.5\times10^6$ S/m to $1.1\times10^7$ S/m, $4.6\times10^6$ S/m to $1\times10^7$ S/m, $4.7\times10^6$ S/m to $0.9\times10^7$ S/m, $4.8\times10^6$ S/m to $0.8\times10^7$ S/m, $4.9\times10^6$ S/m to $0.7\times10^7$ S/m, $0.5\times10^7$ S/m to $0.6\times10^7$ S/m.

In some examples, the method of inkjet printing conductive traces may comprise jetting an inkjet ink composition onto a surface of a substrate, wherein the substrate is heated during printing. In some examples, the method of inkjet printing conductive traces may comprise jetting an inkjet ink composition onto a surface of a substrate, wherein the surface of the substrate comprises a sintering agent and wherein the substrate is heated during printing. In some examples, the substrate may be heated to a temperature of 40°C or more, for example, 45°C or more or 50°C or more. In some examples, the substrate may be heated to a temperature of 100°C or less. In some examples, the substrate may be heated to a temperature of from 40°C to 100°C, for example, from 45°C to 100°C or from 50°C to 100°C. In some examples, the substrate is at room temperature (i.e., from about 20°C to about 25°C) during printing. In some examples, the heated substrate may increase the rate of drying of the inkjet ink composition, reducing the thickness of the conductive traces. In some examples, the reduced thickness of the conductive traces may reduce the resistivity and increase the conductivity.

In some examples, the method of inkjet printing conductive traces may comprise jetting an inkjet ink composition onto a surface of a substrate, wherein the inkjet printing is at a print pitch selected to be less than the diameter of a single droplet in order to overlap printed features and produce a continuous trace. For example, for a 0.090 mm diameter single dried droplet on a paper substrate a print pitch of between 0.085 mm and 0.015 mm, for example, between 0.085 mm and 0.045 mm or between 0.075 mm and 0.065 mm could be selected. For a single droplet diameter of 0.020 mm, a print pitch of between 0.018 mm to 0.002 mm may be selected. In some examples, the print pitch may be from about 10% to about 95% of the diameter of a droplet, for example, from about 15% to about 90%, about 50% to about 95%, about 70% to about 85%, or about 72% to about 83% of the diameter of a droplet.

In some examples, the conductive traces produced by the method of printing an inkjet ink composition form part of a device selected from a flexible battery; an electro-optic device; a display; an organic photovoltaic device; a logic and memory component, such as a thin film transistor; a sensor; and a radio frequency identification device.

*Substrate*

In some examples, the substrate may be any substrate onto which an inkjet ink composition can be jetted. In some examples, the substrate may be any substrate suitable for use in an inkjet printer.

In some examples, the substrate may be selected from glass, plastic, paper and semiconductors. In some examples, the plastic substrate may be selected from polyethylene terephthalate and polyimide. In some examples, the semiconductors may be selected from silicon and polymeric semiconductors. In some examples, the polymeric semiconductors may comprise polyvinyl chloride (PVC), polytetrafluoroethylene (PTFE) or glass-reinforced epoxy laminate such as FR-4.

In some examples, the surface of the substrate may comprise a sintering agent. In some examples, the substrate may be a paper substrate comprising a surface layer that comprises a sintering agent.

In some examples, the sintering agent may be applied to the surface of a substrate by any suitable method, for example, gravure printing, flexo printing, screen printing, inkjet printing or electrospray deposition.

Examples

The following illustrates examples of the compositions, methods and other aspects described herein. Thus, these Examples should not be considered as limitations of the present disclosure, but are merely in place to teach how to make examples of the present disclosure.

Materials

Silver nitrate (AgNOs) was purchased from Alfa Aesar and all the remaining chemicals or solvents, including poly(acrylic acid) (PAA), triethanolamine (TEA), ethanol, 1-propanol and ethylene glycol, were purchased from Sigma Aldrich. Glossy paper was purchased from EPSON (Inkjet Jet D'encre, 5" x 7"), and includes a coating layer comprising chloride ions. Deionized water (DI) of 18 MΩ was used in the synthesis process and ink preparation.

Synthesis of silver nanoparticles

In a typical synthesis of PAA-capped silver nanoparticles, 10.3 ml of TEA and 0.85 mmol of PAA were mixed in a flask containing 48 ml of DI water under stirring (at 500 to 1000 rpm). Then, 10 g of silver nitrate mixed in 10 ml of DI water was slowly added to the above mixture and left under stirring (at 500 to 1000 rpm) at room temperature for 1 hour. Once the silver nitrate is completely dispersed in the solution of PAA and TEA, the mixture turns from pale white to brown in colour. Then, the mixture was heated to a temperature of 70°C for 3 hours under vigorous stirring (at around 1500 rpm). After half an hour the solution turns blackish brown in colour. After 3 hours of vigorous stirring at 70°C, turn off the heat and, once the mixture has cooled to room temperature, sonicate for 1 hour. The obtained poly(acrylic acid)-capped (PAA-capped) silver nanoparticles were washed by centrifugation 4 to 5 times with ethanol and the supernatant was dried at 70°C to collect the solid poly(acrylic acid)-capped silver nanoparticles (SSNPs).

*Characterisation*

The PAA-capped silver nanoparticles were dispersed in water. UV-Vis spectroscopy was performed and the absorption peak was found to be at 408 nm, indicating that the PAA-capped silver nanoparticles have a diameter in the range of 1 nm to 30 nm. The size of the PAA-capped silver nanoparticles was also studied by using TEM images (JEOL 2010 200KV), from which it was observed that the diameter of the nanoparticles was predominantly in the range of 1 nm to 20 nm. Immediately after synthesis of the PAA-capped silver nanoparticles the mean particle diameter was observed to be 102 nm. Sonication during preparation of the inkjet ink composition (see below) reduces the mean particle diameter.

Example 1

Preparation and inkjet printing of the inkjet ink composition

The obtained solid poly(acrylic acid)-capped silver nanoparticles were then used for the preparation of an inkjet ink composition. The inkjet ink was prepared by adding 30 wt.% of the SSNPs to a mixture of water and ethylene glycol (the second hydroxy compound) and sonicated for 30 minutes. Then, 1-proponal (the first hydroxy compound) was added to the mixture and the mixture was stirred for 10 minutes. The weight ratio of water, ethylene glycol (second hydroxy compound) and 1-proponal (first hydroxy compound) used in the inkjet ink composition was 1:0.9:0.8.

The inkjet ink composition was found to have a density of 1.28 g/cm$^3$, a dynamic viscosity of 7 cps and a surface tension of 27.1 dynes/cm.

The inkjet ink composition was printed onto a glossy paper substrate by using a JETLAB4 printer with a nozzle size of 80 $\mu$m or 50 $\mu$m. The glossy paper substrate comprises a coating layer containing chloride ions. The chloride ions immediately initiate low-temperature sintering of the printed inkjet ink composition, causing the PAA capping agent to detach from the silver nanoparticles. The detachment of the PAA capping agent from the silver nanoparticles leads to coalescence of the particles and the formation of conductive traces on the glossy paper substrate.

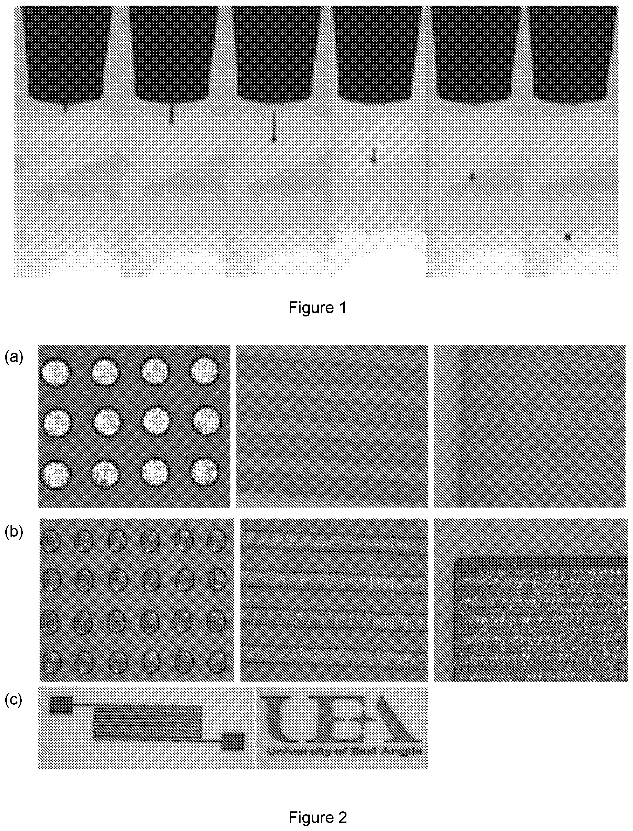

The inkjet ink composition was ejected well and without satellite formation and clogging from the 80 $\mu$m

nozzle. A droplet of ink was observed to eject from the nozzle with a tail and, within a few seconds, the tail merged with the drop, forming a complete droplet without any satellites. This is shown in Figure 1. Inkjet printing the inkjet ink composition with an 80 $\mu$m nozzle size resulted in a diameter of single droplets on the paper of 90 $\mu$m. To further reduce the droplet diameter on the paper, the inkjet printer nozzle size was reduced to 50 $\mu$m and this resulted in a reduction of the single droplet diameter to 80 $\mu$m.

Inkjet printed patterns on glossy paper, such as single droplets, lines and the edge of the pad, printed with a) 80 $\mu$m and b) 50 $\mu$m nozzle diameters are shown in Figure 2. Figure 2 shows the good quality of the inkjet printing of the inkjet ink composition. The droplets on the paper are consistent and the lines and pads have sharp edges without any irregularity. In addition, to observe the printability of the inkjet ink composition, a 2D pattern with a contact pad and the UEA logo were printed on glossy paper with a pixel size of <100 $\mu$m (see Figure 2c).

The thickness of the printed patterns was determined by SEM techniques and showed that a single line printed from the 50 $\mu$m nozzle has a mean thickness of 0.5 to 1.67 $\mu$m and the length and width of the printed single layer trace was 8 mm by 0.08 mm. Depending on the print pitch, the space between droplets on paper may typically be 0.07 to 0.02 mm. The resistivity of this printed single layer trace can be determined by using the following equation:

$$R = \rho L/A = \rho L/wt$$

in which R=resistance (in $\Omega$), $\rho$=resistivity (in $\Omega$m), L=length of the printed trace (in m), A=area of the printed trace (in m$^2$), w=width of the printed trace (in m) and t=thickness of the printed trace (in m). The conductivity of the printed single layer trace can be determined by using the following equation:

$$\sigma = 1/\rho$$

in which $\sigma$=conductivity (in S/m). Using these equations, the resistivity of the printed single layer trace on glossy paper (length 8 mm; width 0.08 mm) was determined to be $1 \times 10^{-7}$ $\Omega$m to $2.5 \times 10^{-7}$ $\Omega$m and the conductivity was determined to be $1 \times 10^{7}$ S/m to $4 \times 10^{6}$ S/m. A resistivity of $8.4 \times 10^{-8}$ $\Omega$m and a conductivity of $1.1 \times 10^{7}$ S/m may be obtained by using the 80 $\mu$m nozzle to print a thicker layer and by printing several successive layers.

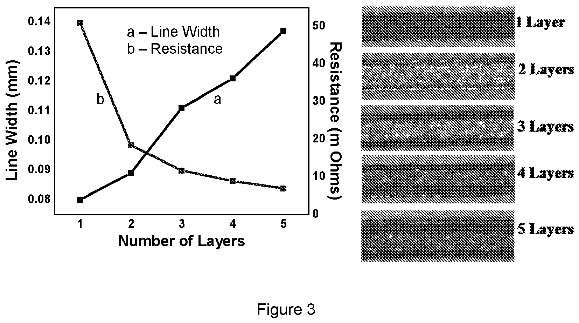

It was observed that the width and resistance of the printed traces changes when additional layers of inkjet ink composition were printed onto the previous layers. As the number of layers of printed inkjet ink composition increases, the width of the printed trace also increases (see graph in Figure 3) and therefore the resistance decreases since it is inversely proportional to the width and thickness of the printed trace. Therefore, as the thickness of the trace increases, the resistance decreases.

Reference ink compositions

The PAA-capped silver nanoparticles were dispersed in water to provide an inkjet ink composition. This composition was found to have a high surface tension that made achieving drop ejection challenging and printing performance was very poor.

The PAA-capped silver nanoparticles were dispersed in a mixture of water and a monohydroxyl-substituted hydrocarbon (an alcohol, such as ethanol or 1-propanol). The presence of the alcohol reduced the surface tension to within the inkjet printing range but it was observed that the ink composition ejected with satellites and nozzle clogging was a problem due to the high vapour pressure of the formulation and fast evaporation of the ink in the inkjet print-head nozzle.

Characterization Methods and Equipment

SEM images were taken with a JSM 5900LV to obtain the thickness of the film. The optical images were collected with a Nikon Eclipse LV150N. To identify the nanoparticles size, transmission electron microscope (TEM) images were obtained by using a JEOL 2010 200KV. The particle size distribution was measured by dynamic light scattering (DLS) by using a ZETASIZER from MALVERN instruments. The inkjet printing was performed by a JETLAB4 printer with a nozzle size of 80 $\mu$m and 50 $\mu$m. To determine the width, thickness and profile of the printed nanoparticle features, a Bruker DektakXT Stylus Profiler was used. The sheet resistance was measured by using a JANDEL RM3000+.

Example 2

Preparation and inkjet printing of the inkjet ink composition

The poly(acrylic acid)-capped silver nanoparticles were synthesised and characterised as described in above and then used for the preparation of an inkjet ink composition. The inkjet ink composition was prepared by adding 30 wt.% of the SSNPs to a mixture of water and ethylene glycol (the second hydroxy compound) and sonicated for 30 minutes. Then, 1-propanol (the first hydroxy compound) was added to the mixture and the mixture was stirred for 10 minutes. The weight ratio of water, ethylene glycol (second hydroxy compound) and 1-propanol (first hydroxy compound) used in the inkjet ink composition was 1:0.5:0.5.

The inkjet ink composition was printed onto a glossy paper substrate by using a JETLAB4 printer with a nozzle size of 50 $\mu$m. The glossy paper substrate comprises a coating layer containing chloride ions. The chloride ions initiate low-temperature sintering of the printed inkjet ink composition, causing the PAA capping agent to detach from the silver nanoparticles. The detachment of the PAA capping agent from the silver nanoparticles leads to coalescence of the particles and the formation of conductive traces on the glossy paper substrate.

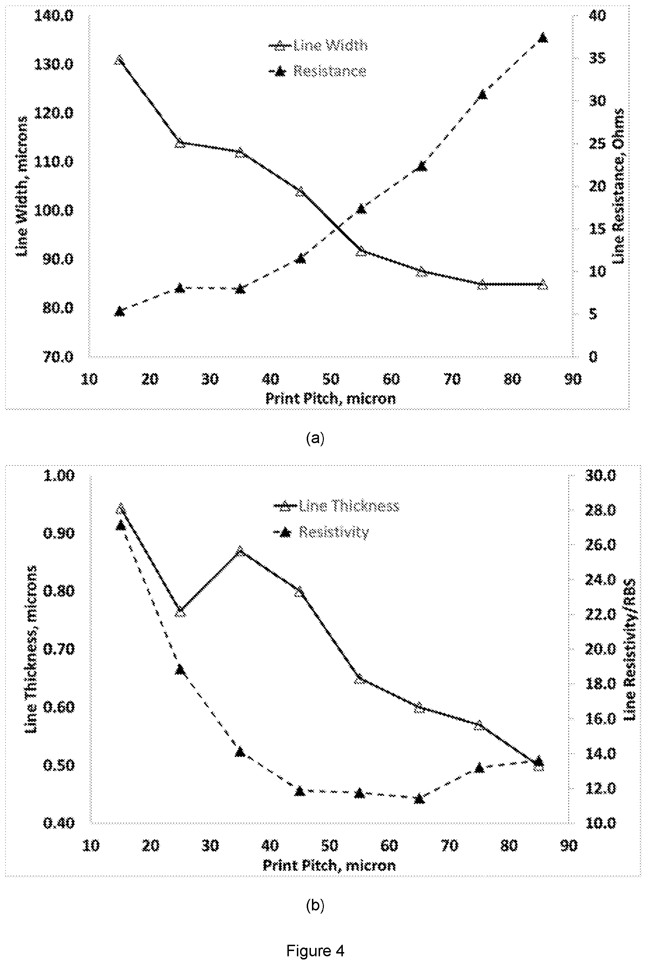

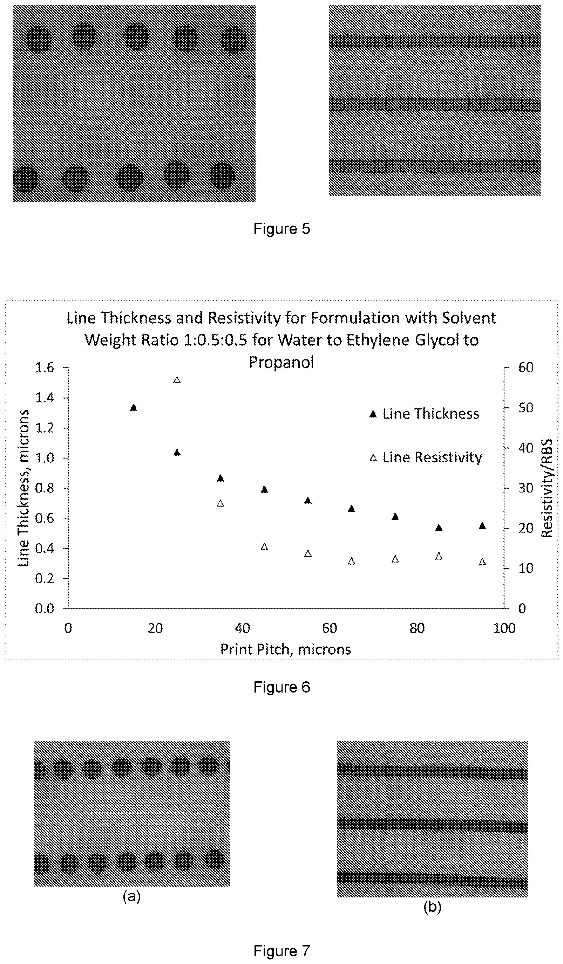

Inkjet printed patterns on glossy paper, including single droplets and continuous lines, printed with 50 $\mu$m nozzle diameters are shown in Figure 4. The droplets on the paper were printed at 200 $\mu$m pitch and are consistent and the lines have sharp edges without any irregularity, example of line printing is shown in Figure 5 for a print pitch of 55 $\mu$m.

To determine the width, thickness and profile of the printed nanoparticle features, a Bruker DektakXT Stylus Profiler was used. The mean thickness of a single pass printed line from the 50 $\mu$m nozzle varied with print pitch (spacing between successive printed pixels) and has a thickness ranging from 0.54 at 85 $\mu$m print pitch to 1.34 $\mu$m at 15 $\mu$m print pitch, as shown in Figure 6. The resistivity of the continuous features can be determined in a similar way to that described in Example 1, where the resistivity of the printed single layer tracks on glossy paper where found to be largely independent of print pitch between 85 to 55 $\mu$m pitch with a value between 11.7 and 13.8 times the resistivity of bulk silver (RBS). At a print pitch of less than 55 $\mu$m, the resistivity was found to increase to reach 57 times RBS at 15 $\mu$m print pitch.

Example 3

Preparation and inkjet printing of the inkjet ink composition

The poly(acrylic acid)-capped silver nanoparticles were synthesised and characterised as described in above and then used for the preparation of an inkjet ink composition. The inkjet ink composition was prepared by adding 30 wt.% of the SSNPs to a mixture of water and ethylene glycol (the second hydroxy compound) and sonicated for 30 minutes. Then, 1-propanol (the first hydroxy compound) was added to the mixture and the mixture was stirred for 10 minutes. The weight ratio of water, ethylene glycol (second hydroxy compound) and 1-propanol (first hydroxy compound) used in the inkjet ink composition was 1:0.5:1.5.

The inkjet ink composition was printed onto a glossy paper substrate by using a JETLAB4 printer with a nozzle size of 50 $\mu$m. The glossy paper substrate comprises a coating layer containing chloride ions. The chloride ions initiate low-temperature sintering of the printed inkjet ink composition, causing the PAA capping agent to detach from the silver nanoparticles. The detachment of the PAA capping agent from the silver nanoparticles leads to coalescence of the particles and the formation of conductive traces on the glossy paper substrate.

Inkjet printed patterns on glossy paper, including single droplets printed at 200 $\mu$m pitch and continuous lines at 55 $\mu$m pitch, printed with a 50 $\mu$m nozzle diameter are shown in Figure 7. The droplets on the paper are consistent and the lines have sharp edges without any irregularity.

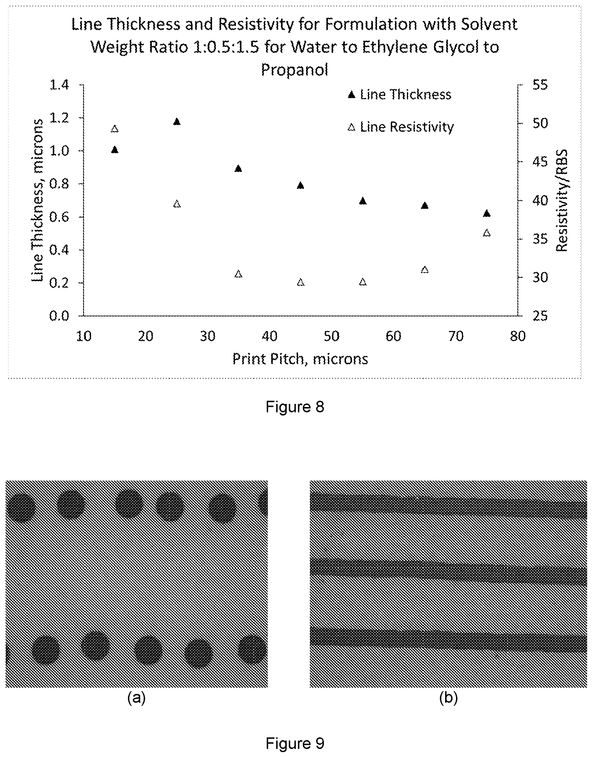

To determine the width, thickness and profile of the printed nanoparticle features, a Bruker DektakXT Stylus Profiler was used. The mean thickness of a single pass printed line from the 50 $\mu$m nozzle varied with print pitch (spacing between successive printed pixels) and has a thickness of ranging from 0.63 at 75 $\mu$m print pitch to 1.01 $\mu$m at 15 $\mu$m print pitch, as shown in Figure 8. The resistivity of the continuous features can be determined in a similar way to that described in the above example, where the resistivity of the printed single layer tracks on glossy paper were found to pass through a minimum value of around 29.5 times RBS at a print pitch between 55 $\mu$m and 45 $\mu$m print pitch, as shown in Figure 8. On decreasing the print pitch below 45 $\mu$m, the resistivity increases and reaches a value of 49.4 times RBS at the lowest print pitch tested (15 $\mu$m print pitch).

Example 4

Preparation and inkjet printing of the inkjet ink composition

The poly(acrylic acid)-capped silver nanoparticles were synthesised and characterised as described in above and then used for the preparation of an inkjet ink composition. The inkjet ink composition was prepared by adding 30 wt.% of the SSNPs to a mixture of water and ethylene glycol (the second hydroxy compound) and sonicated for 30 minutes. Then, 1-propanol (the first hydroxy compound) was added to the mixture and the mixture was stirred for 10 minutes. The weight ratio of water, ethylene glycol (second hydroxy compound) and 1-propanol (first hydroxy compound) used in the inkjet ink composition was 1:1.5:0.5.

The inkjet ink composition was printed onto a glossy paper substrate by using a JETLAB4 printer with a nozzle size of 50 $\mu$m. The glossy paper substrate comprises a coating layer containing chloride ions. The chloride ions initiate low-temperature sintering of the printed inkjet ink composition, causing the PAA capping agent to detach from the silver nanoparticles. The detachment of the PAA capping agent from the silver nanoparticles leads to coalescence of the particles and the formation of conductive traces on the glossy paper substrate.

Inkjet printed patterns on glossy paper, including single droplets at 200 $\mu$m pitch and continuous lines at 55 $\mu$m print pitch, printed with the 50 $\mu$m nozzle diameter are shown in Figure 9. The droplets on the paper are consistent and the lines have sharp edges without any irregularity.

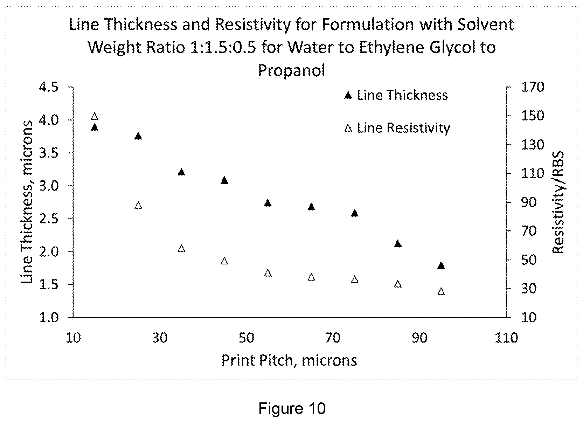

To determine the width, thickness and profile of the printed nanoparticle features, a Bruker DektakXT Stylus Profiler was used. The mean thickness of a single pass printed line from the 50 μm nozzle varied with print pitch (spacing between successive printed pixels) and has a thickness ranging from 1.79 at 95 μm print pitch to 3.90 μm at 15 μm pitch, as shown in Figure 10. The resistivity of the continuous features can be determined in a similar way to that described in the above example, where the resistivity of the printed single layer tracks on glossy paper where found to be largely independent of print pitch between 95 μm and 55 μm pitch with a value between 28 and 41 times resistivity of bulk silver (RBS). At a print pitch of less than 55 μm, the resistivity was found to increase with decreasing print pitch and reach 150 times RBS at 15 μm print pitch.

## Claims

1. An inkjet ink composition for printing conductive traces, comprising:

   polymer-capped metal nanoparticles;
   a first hydroxy compound, which is a monohydroxyl-substituted hydrocarbon comprising 1 to 6 carbon atoms;
   a second hydroxy compound, which is selected from a polyol, a monohydric ether and mixtures thereof; and
   water,
   wherein the weight ratio of water to first hydroxyl compound is in the range of 1:0.5 to 1:1.5; and
   wherein the weight ratio of water to second hydroxy compound is in the range of 1:0.5 to 1:1.5.

2. The inkjet ink composition according to claim 1, wherein the weight ratio of water to first hydroxyl compound is in the range of 1:0.6 to 1:1; and/or wherein the weight ratio of water to second hydroxyl compound is in the range of 1:0.7 to 1:1.1.

3. The inkjet ink composition according to any preceding claim, wherein the first hydroxy compound is selected from methanol, ethanol, 1-propanol, isopropanol, any isomer of butanol, pentanol, hexanol and mixtures thereof.

4. The inkjet ink composition according to any preceding claim, wherein the second hydroxy compound is a polyol; and optionally

   wherein the polyol is selected from ethylene glycol, diethylene glycol, triethylene glycol, propylene glycol, polyethylene glycol) having a molecular weight of 1000 or less, and glycerol; or
   wherein the second hydroxy compound is a monohydric ether.

5. The inkjet ink composition according to any preceding claim, wherein the polymer-capped metal nanoparticles have a mean diameter of 100 nm or less; and/or wherein the polymer capping agent is selected from poly(acrylic acid), poly(vinyl pyrrolidone), poly(maleic acid), poly(methacrylic acid), poly(acrylic acid-co-methacrylic acid), poly(maleic acid-co-acrylic acid), poly(acrylamide-co-acrylic acid), poly[hydroxylethyl(meth)acrylate-co-(meth)acrylic acid], poly[hydroxypropyl-(meth)acrylate-co-(meth)acrylic acid] and poly(methyl methacrylate).

6. The inkjet ink composition according to any preceding claim, wherein the metal nanoparticles are nanoparticles of one metal, alloy nanoparticles or coreshell nanoparticles; and/or
   wherein the polymer-capped metal nanoparticles are poly(acrylic acid)-capped silver nanoparticles.

7. A method of preparing an inkjet ink composition for printing conductive traces, comprising:

   combining polymer-capped metal nanoparticles, a first hydroxy compound, which is a monohydroxyl-substituted hydrocarbon comprising 1 to 6 carbon atoms; a second hydroxy compound, which is selected from a polyol, a monohydric ether and mixtures thereof; and water;
   wherein the weight ratio of water to first hydroxy compound is in the range of 1:0.5 to 1:1.5; and
   wherein the weight ratio of water to second hydroxy compound is in the range of 1:0.5 to 1:1.5.

8. The method of preparing an inkjet ink composition according to claim 7, wherein the polymer-capped metal nanoparticles are combined with the second hydroxy compound and water prior to being combined with the first hydroxy compound.

9. A method of inkjet printing conductive traces, comprising:

   jetting an inkjet ink composition onto a surface of a substrate, the inkjet ink composition comprising:

   polymer-capped metal nanoparticles;
   a first hydroxy compound, which is a monohydroxyl-substituted hydrocarbon comprising 1 to 6 carbon atoms;
   a second hydroxy compound, which is selected from a polyol, a monohydric ether and mixtures thereof; and
   water,

   wherein the weight ratio of water to first hydroxyl compound is in the range of 1:0.5 to 1:1.5; and
   wherein the weight ratio of water to second hydroxy compound is in the range of 1:0.5 to 1:1.5.

10. The method of inkjet printing according to claim 9, wherein the surface of the substrate comprises a sintering agent.

11. The method of inkjet printing according to claim 9, wherein after the inkjet ink composition is jetted onto the surface of the substrate, a sintering agent is applied to the printed inkjet ink composition.

12. The method of inkjet printing according to any one of claims 9 to 11, wherein the substrate is selected from glass, plastic, paper and semiconductors.

13. The method of inkjet printing according to claim 10, wherein the substrate is paper and the paper comprises a surface layer comprising the sintering agent.

14. The method of inkjet printing according to any one of claims 10 to 13, wherein the sintering agent comprises chloride ions; and optionally wherein the sintering agent is selected from KCl, NaCl, $MgCl_2$, $AlCl_3$, LiCl, $CaCl_2$, HCl or a chloride containing polymer.

15. The method of inkjet printing according to any one of claims 9 to 14, wherein the jetted ink composition is sintered at a temperature of 50°C or less; and/or wherein the conductive trace forms part of a device selected from a flexible battery; an electro-optic device; a display; an organic photovoltaic device; a logic and memory component, such as a thin film transistor; a sensor; and a radio frequency identification device.

**Patentansprüche**

1. Tintenstrahltintenzusammensetzung zum Drucken von Leiterbahnen, umfassend:

   Metallnanopartikel mit Polymer-Cap;
   eine erste Hydroxyverbindung, die ein monohydroxysubstituierter Kohlenwasserstoff ist, der 1 bis 6 Kohlenstoffatomen umfasst;
   eine zweite Hydroxyverbindung, die aus einem Polyol, einem einwertigen Ether und Mischungen davon ausgewählt ist; und Wasser,
   wobei das Gewichtsverhältnis von Wasser zu der ersten Hydroxyverbindung im Bereich von 1:0,5 bis 1:1,5 liegt; und
   wobei das Gewichtsverhältnis von Wasser zu der zweiten Hydroxyverbindung im Bereich von 1:0,5 bis 1:1,5 liegt.

2. Tintenstrahltintenzusammensetzung nach Anspruch 1, wobei das Gewichtsverhältnis von Wasser zu der ersten Hydroxylverbindung im Bereich von 1:0,6 bis 1:1 liegt; und/oder

   wobei das Gewichtsverhältnis von Wasser zu der zweiten Hydroxyverbindung im Bereich von 1:0,7 bis 1:1,1 liegt.

3. Tintenstrahltintenzusammensetzung nach einem der vorhergehenden Ansprüche, wobei die erste Hydroxyverbindung aus Methanol, Ethanol, 1-Propanol, Isopropanol, einem beliebigen Isomeren von Butanol, Pentanol, Hexanol und Mischungen davon ausgewählt ist.

4. Tintenstrahltintenzusammensetzung nach einem der vorhergehenden Ansprüche, wobei die zweite Hydroxyverbindung ein Polyol ist; und optional

   wobei das Polyol aus Ethylenglykol, Diethylenglykol, Triethylenglykol, Propylenglykol, Poly(ethylenglykol) mit einem Molekulargewicht von 1000 oder weniger und Glyzerin ausgewählt ist; oder
   wobei die zweite Hydroxyverbindung ein einwertiger Ether ist.

5. Tintenstrahltintenzusammensetzung nach einem der vorhergehenden Ansprüche, wobei die Metallnanopartikel mit Polymer-Cap einen mittleren Durchmesser von 100 nm oder weniger aufweisen; und/oder
   wobei das Polymer-Capping-Mittel aus Poly(acrylsäure), Poly(vinylpyrrolidon), Poly(maleinsäure), Poly(methacrylsäure), Poly(acrylsäure-comethacrylsäure), Poly(maleinsäure-co-acrylsäure), Poly(acrylamid-co-acrylsäure), Poly[hydroxyethyl(meth)acrylat-co-(meth)acrylsäure], Poly[hydroxypropyl(meth)acrylat-co-(meth)acrylsäure] und Poly(methylmethacrylat) ausgewählt ist.

6. Tintenstrahltintenzusammensetzung nach einem der vorhergehenden Ansprüche, wobei die Metallnanopartikel Nanopartikel eines Metalls, Legierungsnanopartikel oder Kern-Schale-Nanopartikel sind; und/oder
   wobei die Metallnanopartikel mit Polymer-Cap Silbernanopartikel mit Poly(acrylsäure)-Cap sind.

7. Verfahren zum Herstellen einer Tintenstrahltintenzusammensetzung zum Drucken von Leiterbahnen, umfassend:

   Kombinieren von Metallnanopartikeln mit Polymer-Cap, einer ersten Hydroxyverbindung, die ein monohydroxysubstituierter Kohlenwasserstoff ist der 1 bis 6 Kohlenstoffatome umfasst; einer zweiten Hydroxyverbindung, die aus einem Polyol, einem einwertigen Ether und Mischungen davon ausgewählt ist; und Wasser;
   wobei das Gewichtsverhältnis von Wasser zu der ersten Hydroxyverbindung im Bereich von 1:0,5 bis 1:1,5 liegt; und
wobei das Gewichtsverhältnis von Wasser zu der zweiten Hydroxyverbindung im Bereich von 1:0,5 bis 1:1,5 liegt.

8. Verfahren zur Herstellung einer Tintenstrahltintenzusammensetzung nach Anspruch 7, wobei die Metallnanopartikel mit Polymer-Cap mit der zweiten Hydroxyverbindung und Wasser kombiniert werden, bevor sie mit der ersten Hydroxyverbindung kombiniert werden.

9. Verfahren zum Tintenstrahldrucken von Leiterbahnen, umfassend:
Sprühen einer Tintenstrahltintenzusammensetzung auf eine Oberfläche eines Substrats, wobei die Tintenstrahltintenzusammensetzung umfasst:

Metallnanopartikel mit Polymer-Cap;
eine erste Hydroxyverbindung, die ein monohydroxysubstituierter Kohlenwasserstoff ist, der 1 bis 6 Kohlenstoffatomen umfasst;
eine zweite Hydroxyverbindung, die aus einem Polyol, einem einwertigen Ether und Mischungen davon ausgewählt ist; und Wasser,
wobei das Gewichtsverhältnis von Wasser zu der ersten Hydroxyverbindung im Bereich von 1:0,5 bis 1:1,5 liegt; und
wobei das Gewichtsverhältnis von Wasser zu der zweiten Hydroxyverbindung im Bereich von 1:0,5 bis 1:1,5 liegt.

10. Verfahren zum Tintenstrahldrucken nach Anspruch 9, wobei die Oberfläche des Substrats ein Sintermittel umfasst.

11. Verfahren zum Tintenstrahldrucken nach Anspruch 9, wobei nach dem Sprühen der Tintenstrahltintenzusammensetzung auf die Oberfläche des Substrats ein Sintermittel auf die aufgedruckte Tintenstrahltintenzusammensetzung aufgebracht wird.

12. Verfahren zum Tintenstrahldrucken nach einem der Ansprüche 9 bis 11, wobei das Substrat aus Glas, Kunststoff, Papier und Halbleitern ausgewählt ist.

13. Verfahren zum Tintenstrahldrucken nach Anspruch 10, wobei das Substrat Papier ist und das Papier eine Oberflächenschicht umfasst, die das Sintermittel umfasst.

14. Verfahren zum Tintenstrahldrucken nach einem der Ansprüche 10 bis 13, wobei das Sintermittel Chloridionen umfasst; und wobei optional das Sintermittel aus KCl, NaCl, $MgCl_2$, $AlCl_3$, LiCl, $CaCl_2$, HCl oder einem Chlorid enthaltenden Polymer ausgewählt ist.

15. Verfahren zum Tintenstrahldrucken nach einem der Ansprüche 9 bis 14, wobei die gesprühte Tintenzusammensetzung bei einer Temperatur von 50 °C oder darunter gesintert wird; und/oder wobei die Leiterbahn einen Teil einer Vorrichtung bildet, die aus einer flexiblen Batterie; einer elektrooptischen Vorrichtung; einer Anzeige; einer organischen Fotovoltaikvorrichtung; einer Logik- und Speicherkomponente, wie etwa einem Dünnschichttransistor; einem Sensor; und einer Hochfrequenz-Identifikationseinrichtung ausgewählt ist.

**Revendications**

1. Composition d'encre pour impression à jet d'encre de traces conductrices comprenant :

des nanoparticules métalliques coiffées de polymère ;
un premier composé hydroxylé qui est un hydrocarbure monohydroxyl-substitué comprenant 1 à 6 atomes de carbone ;
un second composé hydroxylé choisi parmi un polyol, un éther monohydrique et des mélanges de ceux-ci ; et
de l'eau,
dans laquelle le rapport pondéral de l'eau au premier composé hydroxylé est situé dans la plage de 1:0,5 à 1:1,5 ; et
dans laquelle le rapport pondéral de l'eau au second composé hydroxylé est situé dans la plage de 1:0,5 à 1:1,5.

2. Composition d'encre pour jet d'encre selon la revendication 1, dans laquelle le rapport pondéral de l'eau au premier composé hydroxylé est situé dans la plage de 1:0,6 à 1:1 ; et/ou
dans laquelle le rapport pondéral de l'eau au second composé hydroxylé est situé dans la plage de 1:0,7 à 1:1,1.

3. Composition d'encre pour jet d'encre selon une quelconque revendication précédente, dans laquelle le premier composé hydroxylé est choisi parmi le méthanol, l'éthanol, le 1-propanol, l'isopropanol, un quelconque isomère du butanol, le pentanol, l'hexanol et des mélanges de ceux-ci.

4. Composition d'encre pour jet d'encre selon une quelconque revendication précédente, dans laquelle le second composé hydroxylé est un polyol ; et éventuellement

dans laquelle le polyol est choisi parmi l'éthylène glycol, le diéthylène glycol, le triéthylène glycol, le propylène glycol, le poly(éthylène glycol) présentant un poids moléculaire inférieur ou égal à 1 000, et le glycérol ; ou

dans laquelle le second composé hydroxylé est un éther monohydrique.

5. Composition d'encre pour jet d'encre selon une quelconque revendication précédente, dans laquelle les nanoparticules métalliques coiffées de polymère ont un diamètre moyen inférieur ou égal à 100 nm ; et/ou dans laquelle l'agent de coiffage polymère est choisi parmi le poly(acide acrylique), la poly(vinylpyrrolidone), le poly(acide maléique), le poly(acide méthacrylique), le poly(acide acrylique-co-acide méthacrylique), le poly(acide maléique-co-acide acrylique), le poly(acrylamide-co-acide acrylique), le poly[(méth)acrylate d'hydroxyéthyle-co-acide (méth)acrylique], le poly[(méth)acrylate d'hydroxypropyle-co-acide (méth)acrylique] et le poly(méthacrylate de méthyle).

6. Composition d'encre pour jet d'encre selon une quelconque revendication précédente, dans laquelle les nanoparticules métalliques sont des nanoparticules d'un métal, des nanoparticules en alliage ou des nanoparticules à enveloppe et noyau ; et/ou dans laquelle les nanoparticules métalliques coiffées de polymère sont des nanoparticules d'argent coiffées de poly(acide acrylique).

7. Procédé de préparation d'une composition d'encre pour impression par jet d'encre de traces conductrices, comprenant :

la combinaison de nanoparticules métalliques coiffées de polymère, d'un premier composé hydroxylé, qui est un hydrocarbure monohydroxyl-substitué comprenant 1 à 6 atomes de carbone ; d'un second composé hydroxylé, qui est choisi parmi un polyol, un éther monohydrique et des mélanges de ceux-ci ; et d'eau ; dans lequel le rapport pondéral de l'eau au premier composé hydroxylé est situé dans la plage de 1:0,5 à 1:1,5 ; et dans laquelle le rapport pondéral de l'eau au second composé hydroxylé est situé dans la plage de 1:0,5 à 1:1,5.

8. Procédé de préparation d'une composition d'encre pour jet d'encre selon la revendication 7, dans lequel les nanoparticules métalliques coiffées de polymère sont combinées avec le second composé hydroxylé et de l'eau avant d'être combinées avec le premier composé hydroxylé.

9. Procédé d'impression à jet d'encre de traces conductrices comprenant :
la projection d'une composition d'encre pour jet d'encre sur une surface d'un substrat, la composition d'encre pour jet d'encre comprenant :

des nanoparticules métalliques coiffées de polymère ; un premier composé hydroxylé qui est un hydrocarbure monohydroxyl-substitué comprenant 1 à 6 atomes de carbone ; un second composé hydroxylé choisi parmi un polyol, un éther monohydrique et des mélanges de ceux-ci ; et de l'eau, dans laquelle le rapport pondéral de l'eau au premier composé hydroxylé est situé dans la plage de 1:0,5 à 1:1,5 ; et dans laquelle le rapport pondéral de l'eau au second composé hydroxylé est situé dans la plage de 1:0,5 à 1:1,5.

10. Procédé d'impression à jet d'encre selon la revendication 9, dans lequel la surface du substrat comprend un agent de frittage.

11. Procédé d'impression à jet d'encre selon la revendication 9, dans lequel, après la projection de la composition d'encre pour jet d'encre sur la surface du substrat, un agent de frittage est appliqué sur la composition d'encre pour jet d'encre imprimée.

12. Procédé d'impression à jet d'encre selon l'une quelconque des revendications 9 à 11, dans lequel le substrat est choisi parmi le verre, le plastique, le papier et les semi-conducteurs.

13. Procédé d'impression à jet d'encre selon la revendication 10, dans lequel le substrat est du papier et le papier comprend une couche superficielle comprenant l'agent de frittage.

14. Procédé d'impression à jet d'encre selon l'une quelconque des revendications 10 à 13, dans lequel l'agent de frittage comprend des ions chlorure ; et éventuellement dans lequel l'agent de frittage est choisi parmi KCl, NaCl, $MgCl_2$, $AlCl_3$, LiCl, $CaCl_2$, HCl ou un polymère contenant du chlorure.

15. Procédé d'impression à jet d'encre selon l'une quelconque des revendications 9 à 14, dans lequel la composition d'encre projetée est frittée à une température inférieure ou égale à 50 °C ; et/ou dans lequel la trace conductrice fait partie intégrante d'un dispositif sélectionné parmi une batterie flexible ; un dispositif électro-optique ; un affichage ; un dispositif photovoltaïque organique ; un composant logique et de mémoire, tel qu'un transistor à film mince ; un capteur ; et un dispositif d'identification par radiofréquence.

Figure 1

Figure 2

Figure 3

(a)

(b)

Figure 4

Figure 5

Figure 6

Figure 7

Figure 8

(a)

(b)

Figure 9

Figure 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007289483 A1

**Non-patent literature cited in the description**

- **SHLOMO MAGDASSI ; MICHAEL GROUCHKO ; OLEG BEREZIN ; ALEXANDER KAMYSHNY.** *ACS Nano,* 2010, vol. 4 (4), 1943-1948
- **QIJIN HUANG ; WENFENG SHEN ; QINGSONG XU ; RUIQIN TAN ; WEIJIE SONG.** *Materials Chemistry and Physics,* 2014, vol. 147, 550-556
- **T. OHLUND ; A. SCHUPPERT ; B. ANDRES ; H. ANDERSSON ; S. FORSBERG ; W. SCHMIDT ; H-E. NILSSON ; M. ANDERSSON ; R. ZHANG ; H. OLIN.** Assited sintering of silver nanoparticle inkjet ink on paper with active coatings. *RSC Advances,* 2015
- **L. CAO ; X. BAI ; Z. LIN ; P. ZHANG ; S. DENG ; X. DU ; W. LEI.** The preparation of Ag Nanoparticle and Ink Used for Inkjet Printing of Paper Based Conductive Patterns. *Materials,* 2017